# EUROPEAN PATENT SPECIFICATION

(11) **EP 1 809 695 B1**
(45) Date of publication and mention of the grant of the patent: **09.09.2009**
(21) Application number: 05808251.2
(22) Date of filing: 07.11.2005
(51) Int. Cl.: C08K 5/3492, H01R 13/50, H05K 5/02, C08L 77/00

(54) **POWER SUPPLY ENCLOSURE**
STROMVERSORGUNGSGEHÄUSE
BOITIER D'ALIMENTATION ELECTRIQUE

(30) Priority: 10.11.2004 EP 04078097
(43) Date of publication of application: 25.07.2007
(73) Proprietor: DSM IP Assets B.V., 6411 TE Heerlen (NL)
(72) Inventor: GURP VAN, Marnix, NL-6137 LM Sittard (NL); MARKWARDT, Jens Frank, DSM Engineering Plastics, Shanghai 200020 (CN)
(74) Representative: Verhaegen, Ilse Maria M.
(86) International application number: PCT/EP2005/011963
(87) International publication number: WO 2006/050920

(56) References cited:
- EP-A- 0 048 930
- EP-A- 1 544 240
- US-B1- 6 204 314
- US-B1- 6 454 604

## Description

The invention relates to a power supply enclosure.

An increasing number of electric and electronic appliances, as wireless telephone sets, cellular phones, photo and video cameras, are equipped with rechargeable batteries. Most of such appliances come with a power supply that can be connected to the appliance itself to directly and continuously feed it, to recharge the battery inside it or into which the rechargeable battery can be placed to recharge it The power supply normally consists of an enclosure provided with a two or three contact connector for connecting it to the 110/220 V main electricity net. The enclosure contains at least the circuitry for transforming the high AC voltage into the required low DC voltage and, if applicable, room for a battery to be charged.

At present these enclosures are usually made of PC, ABS or a PC/ABS blend. This material gives a cold and hard feel when handled by a person. This problem was already recognized on cellular phones and it was solved by manufacturing the enclosure of these phones In a two layer or two materials concept-in which the parts that are touched when gripping the phone are made of a rubbery material such as a TPE or TPV. This concept is not feasible for power supply enclosures since these are subject to requirements of safety In electrical insulation and burning properties as flame retardance, expressed as a UL94 classification, In particular VO and/or safety standards as UL 60950, UL 1310, EN 60950, EN 61558, EN 60335.

Further the good feel is to a large extent caused by a certain surface roughness that gives it a dead appearance.

Another requirement is a cost effective production, among other things by low material use and easy assembling. The thickness of PC/ASS enclosures ranges from 1.6 to 2.0 mm. This problem is also addressed in US 6,454,604 B1. The solution proposed there is to apply a two-layer enclosure, the inner layer being polyester and the second, outer layer consisting of polyvinyl chloride. The thickness of the polyester layer is 0.8 mm and the outer PVC layer is 1 mm thick. The total thickness is 1.8 mm, giving hardly any materials saving compared to the prior art PC/ABS enclosures and the process for manufacturing the enclosure is complex due to the two-layer structure.

US 6,204,314 B1 relates to a flame retardant polyamide resin composition comprising an aliphatic polyamide resin mixture and a melamine cyanurate flame retarder. A power supply enclosure is not disclosed.

The invention now aims to provide a power supply enclosure that requires less material than the known enclosures and gives a pleasant feel when gripped.

This aim is achieved in that the power supply enclosure comprises at least a top part and a bottom part, the top and bottom part having a wall thickness of 1.5 mm or less and consists of a polyamide composition comprising an aliphatic polyamide and a halogen-free flame retarding component.

Surprisingly it has been found that an enclosure of the specific flame retarding polyamide at a low wall thickness, so at low material use, gives a pleasant feel to the enclosure in combination with a smooth shiny appearance.

A further advantage of the enclosure is its better resistance to chemicals, as required by e.g. the severe tests Nokia prescribes for these types of housings. In this test the changes in color, gloss, the occurrence of blistering or cracking are visually checked after exposure for 24 hours and in an ageing cycle test. The enclosure of the invention performs clearly better than the known enclosures.

Another advantage of the specific material choice is that an even more cost effective production has appeared to be possible by connecting top part and bottom part by a film hinge. This allows producing the enclosure in one molding step and also allows a simpler, one screw securing for closing the enclosure. Power supply enclosures also have to satisfy a drop test. When a two part enclosure is applied at least two securing points, e.g. two screws, are required to pass this test, in contrast to the enclosure of the invention in which a one screw securing has been found sufficient to pass the drop test. The film hinge can extent along facing full sides of the top and wall part resp. but it is also possible to have on or more connecting parts, only extending along part of said facing sides.

The enclosure according to the invention can have a wall thickness of even lower than 1.2 or lower than 0.9 mm and still have the required safety and mechanical properties.

The enclosure comprises a top and a bottom part. These Parts are constructed so as to match together to allow them to form a closed enclosure. Such constructions are known as such in the art. Next to a larger flat wall area at feast one of the parts also has raising borders along at least part of its circumference in order to create an empty volume when top and bottom part are mounted together. In said borders or in the flat areas openings may be present for leading in wires for electrically connecting the power supply to the appliance.

Preferably the enclosure is provided with an integrated, in particular molded-in plug for connecting the power supply to the main net. The enclosure thus essentially has the shape of a box, having a top and a bottom surface, formed by the flat wall areas of the top and bottom parts and connected by side walls formed by the raising borders mentioned before. The plug then protrudes from this box, e.g. essentially perpendicular to the flat wall area of one of the top or bottom part or parallel to the flat wall area perpendicularly protruding from one of the raised border sides.

The wall thickness, in this respect meaning the thickness of the flat wall areas of the top and bottom part is 1.5 mm or less down to even 0.9 mm or less. It may even be as low as 0.4 or even 0.3 mm and still giving sufficient mechanical strength to the enclosure. As a well-known technique in the art, on the inside of the flat wall areas protrusions or ridges may be present to enhance the mechanical strength. Wall thickness then is measured between these protrusions or ridges.

For similar constructive reasons the wall thickness at or near the edges of the enclosure may be thicker than that of flat wall areas of the top and bottom part. A larger thickness is also allowable by the presence of constructional elements serving to make the two parts match in such a way so as to avoid the enclosure from bursting at the matching locations when the enclosure accidentally is dropped.

A further easier and more cost effective production process of the enclosure is achieved when it is molded as one piece, the top and bottom part being connected by a film hinge, which is understood to be a thin strip of the same material as the top and bottom parts that forms a flexible but firm connection between these parts.

The enclosure consists of a polyamide composition, comprising an aliphatic polyamide. Examples of suitable aliphatic polyamides are polyamide 6, 6,6, 4,6, 11, 12. Polyamide 6 or a mixture thereof with polyamide 6,6 is preferred for giving the most pleasant feel. Also mixtures of aliphatic polyamides are suitable. Preferably the polyamide in the composition consists for at leas 60 % of polyamide 6 of a mixture thereof with polyamide 6,6. Also minor amounts of non-aliphatic, e.g. of aromatic polyamides may be present I the composition. Preferably at least 80% of he composition are aliphatic polyamides. The polyamides in general have better flow properties than the known PC/ABS compositions, allowing more complex enclosure design. Flow properties of the polyamide composition can even be enhanced by adding flow improvers, preferably by adding a polyamide oligomer. A polyamide oligomer is herein understood to be a low-molecular polyamide with a weight-average molecular weight of at most 7500. Preferably, the weight-average molecular weight is lower than the "molecular weight between entanglements" of the high-molecular polymer. This "molecular weight between entanglements" is for example 5,000 g/mol in the case of PA-6. Also preferably the weight average molecular weight of the polyamide oligomer is at most 5,000 g/mol, more preferably at most 4,000 g/mol, even more preferably at most 3,000 g/mol. The molecular weight of the polyamide oligomer may not be too low either, to avoid the risk of for example the glass transition temperature being lowered. Preferably the weight-average molecular weight is greater than approximately 1,000 g/mol.

The composition further comprises a halogen-free flame retardant. Examples of suitable halogen-free flame retardants are phosphorous and triazine based flame retardants. Triazine based, in particular melamine based flame retardants are preferred. Examples of these are melamine phosphates and melamine condensates as melam and melem. Melamine cyanurate is preferred since it has appeared that the best feel is achieved when the flame retardant consists for at least 60 wt.% of melamine cyanurate.

The amount of flame retardant with respect to the total of polyamide and flame retardant is from 3 to 25 wt%. Although minor amounts of less than 10 wt% of non-halogen-free flame retardants with respect to the halogen-free flame retardant may be present in the composition their presence is not preferred.

It has been found that this composition already at low wall thickness of less than 1.5 mm gives a favorable combination of desired properties, being a pleasant feel, mechanical strength sufficient to pass the drop test of IEC-60028-2-32 Ed. 2 and the safety test of UL 60950, electrical safety and VO UL94 burning and drip behavior classification.

Further the composition may comprise the usual additives known in the art to impart other desired properties to the polyamide compositions. Examples of these other components are UV-, heat- and processing stabilizers, mineral filters, colorants as dyes and pigments. The amounts of these components may vary in view of the desired effect but preferably the total of these other components is less than 20 wt% with respect to total of the polyamide composition in order not to diminish the feel and appearance of the enclosure. Also fibers or other reinforcing compounds may be present in minor amounts of at most 30 wt% but care must be taken not to have their presence deteriorate the required properties, in particular the surface appearance of the enclosure.

The invention will be further elucidated by the following drawings, wherein:
Fig. 1 is a top view of an opened enclosure.
Fig. 2 is a side view of the enclosure of Fig. 1.

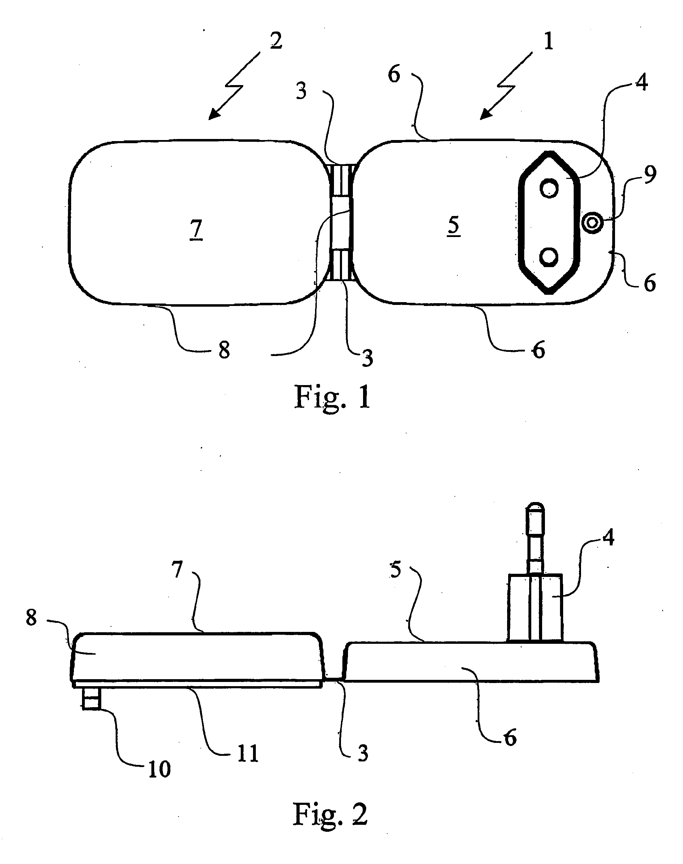

In Fig 1, 1 is the top part of the enclosure and 2 is the bottom part. A two-part film hinge 3 connects top part 1 and bottom part 2. 4 is a two-pin mains connector. Top part 1 comprises a flat wall area 5 and a raising border 6 surrounding this flat wall area 5. Bottom part 2 comprises a flat wall area 7 and a raising border 8 surrounding this flat wall area 7. Shape and size of the raising borders are such that they match to form a tight enclosure when parts 1 and 2 are folded around hinge 3 and contacted. Top and bottom part can be secured by a screw through hole 9 fitting in a corresponding protrusion on the inside of bottom part 2 (See Fig. 2, not visible in this view). In the facing parts of the raising borders 6 and 8 that are connected by the film hinge, an opening (not visible) is present for the connecting chord for the appliance.

In Fig 2. the same elements as in Fig. 1 are visible and in addition hollow protrusion 10 to receive a screw sticking through hole 9 (see Fig. 1, not visible in this view) for securing the enclosure in its closed state. Raising border 8 shows a collar 11 that fits inside raising border 6.

## Claims

1. Power supply enclosure comprising at least a top part and a bottom part, the top and bottom part having a wall thickness of 1.5 mm or less and consisting of a polyamide composition comprising an aliphatic polyamide and a halogen free flame retarding compound.

2. Enclosure according to claim 1, wherein the halogen free flame retardant compound is a melamine based flame retardant compound.

3. Enclosure according to claims 1 or 2, wherein the melamine based flame retardant compound comprises melamine cyanurate

4. Enclosure according to any one of claims 1 to 3, wherein the top and bottom part are connected by a film hinge.

5. Enclosure according to any one of claims 1 to 4, the wall thickness being at most 0.9 mm.

6. Enclosure according to any one of claims 1 to 5, the wall thickness being at least 0.3 mm.

## Patentansprüche

1. Stromversorgungsgehäuse, umfassend mindestens ein Oberteil und ein Unterteil, wobei das Oberteil und das Unterteil eine Wanddicke von 1,5 mm oder weniger aufweisen und aus einer Polyamidzusammensetzung, umfassend ein aliphatisches Polyamid und eine halogenfreie Flammschutzverbindung, bestehen.

2. Gehäuse nach Anspruch 1, wobei die halogenfreie Flammschutzverbindung eine Flammschutzverbindung auf Melaminbasis ist.

3. Gehäuse nach Anspruch 1 oder 2, wobei die Flammschutzverbindung auf Melaminbasis Melamincyanurat umfasst.

4. Gehäuse nach einem der Ansprüche 1 bis 3, wobei das Ober- und Unterteil über ein Filmscharnier verbunden sind.

5. Gehäuse nach einem der Ansprüche 1 bis 4, wobei die Wanddicke höchstens 0,9 mm beträgt.

6. Gehäuse nach einem der Ansprüche 1 bis 5, wobei die Wanddicke mindestens 0,3 mm beträgt.

## Revendications

1. Boîtier d'alimentation électrique comprenant au moins une partie supérieure et une partie inférieure, les parties supérieure et inférieure ayant une épaisseur de paroi de 1,5 mm ou moins, et étant constituées d'une composition de polyamide comprenant un polyamide aliphatique et un composé retardateur de flamme exempt d'halogène.

2. Boîtier selon la revendication 1, dans lequel le composé retardateur de flamme exempt d'halogène est un composé retardateur de flamme à base de mélamine.

3. Boîtier selon la revendication 1 ou 2, dans lequel le composé retardateur de flamme à base de mélamine comprend du cyanurate de mélamine.

4. Boîtier selon l'une quelconque des revendications 1 à 3, dans lequel les parties supérieure et inférieure sont connectées par une charnière à film.

5. Boîtier selon l'une quelconque des revendications 1 à 4, dans lequel l'épaisseur de paroi est au plus de 0,9 mm.

6. Boîtier selon l'une quelconque des revendications 1 à 5, dans lequel l'épaisseur de paroi est au moins de 0,3 mm.
